# EUROPÄISCHE PATENTSCHRIFT

(11) **EP 2 195 669 B1**
(45) Veröffentlichungstag und Bekanntmachung des Hinweises auf die Patenterteilung: **12.01.2011**
(21) Anmeldenummer: 08802776.8
(22) Anmeldetag: 02.10.2008
(51) Int. Cl.: G01R 31/28

(54) **PLUNGER ZUM HALTEN UND BEWEGEN VON ELEKTRONISCHEN BAUELEMENTEN, INSBESONDERE IC'S MIT WÄRMELEITKÖRPER**
PLUNGER FOR HOLDING AND MOVING ELECTRONIC COMPONENTS IN PARTICULAR IC'S WITH A HEAT CONDUCTING BODY
PLONGEUR POUR MAINTENIR ET DÉPLACER DES COMPOSANTS ÉLECTRONIQUES, NOTAMMENT DES CIRCUITS INTÉGRÉS, AVEC UN CORPS THERMOCONDUCTEUR

(30) Priorität: 05.10.2007 DE 102007047679
(43) Veröffentlichungstag der Anmeldung: 16.06.2010
(73) Patentinhaber: Multitest elektronische Systeme GmbH, 83026 Rosenheim (DE)
(72) Erfinder: JESERER, Günther, 83104 Tuntenhausen (DE); VAROL, Efe, 83026 Rosenheim (DE)
(74) Vertreter: Bauer, Friedrich
(86) Internationale Anmeldenummer: PCT/EP2008/008390
(87) Internationale Veröffentlichungsnummer: WO 2009/046946

(56) Entgegenhaltungen:
- WO-A-97/15837
- US-A- 5 147 821
- US-A- 5 977 785
- US-A1- 2006 261 833

## Beschreibung

Die Erfindung betrifft einen Plunger zum Halten und Bewegen von elektronischen Bauelementen, insbesondere zum Zuführen und Wegbewegen von IC's zu bzw. von einer mit einer Testvorrichtung verbundenen Kontakteinrichtung, mit einem Plungerkopf, der mindestens einen Saugkopf zum Ansaugen eines Bauelements und einen Wärmeleitkörper aufweist, gemäß dem Oberbegriff des Anspruches 1.

Elektronische Bauelemente, wie beispielsweise IC's (Halbleiterbauelemente mit integrierten Schaltungen), werden üblicherweise auf ihre Funktionsfähigkeit hin überprüft, bevor sie beispielsweise auf Leiterplatten montiert oder anderweitig verwendet werden. Die zu testenden Bauelemente werden hierbei von einem üblicherweise als "Handler" bezeichneten Handhabungsautomaten mit Kontakteinrichtungen kontaktiert, die insbesondere als Kontaktsockeln ausgebildet sind und mit einem Testkopf einer Testvorrichtung in elektrischem Kontakt stehen. Nach Beendigung des Testvorgangs werden die Bauelemente mittels des Handlers wieder von den Kontakteinrichtungen entfernt und in Abhängigkeit des Testergebnisses sortiert.

Zum Halten und Kontaktieren der Bauelemente weisen Handler üblicherweise Plunger auf, d.h. längsverschiebbare, kolbenartig hin- und herbewegbare Halteeinheiten, welche die Bauelemente insbesondere durch Aufbringen einer Saugkraft mittels Vakuum halten können. Die Plunger werden nach dem Aufsetzen der Bauelemente innerhalb des Handlers in eine Position gebracht, in der sie auf geradlinigem Weg weiter zu Kontakteinrichtungen vorgeschoben werden können, bis die Bauelemente mit den Kontakteinrichtungen in Kontakt gelangen. Nach Durchführung der Testvorgänge werden die Bauelemente mittels der Plunger wieder vom Testkopf entfernt und derart positioniert, dass sie über eine Entladestation aus dem Handler entfernt und in Abhängigkeit des Testergebnisses sortiert werden können.

Um die Tests unter bestimmten Temperaturbedingungen durchführen zu können, ist es weiterhin bekannt, die Bauelemente vor dem Testvorgang auf bestimmte Temperaturen zu temperieren. Diese Temperaturen können beispielsweise in einem Bereich von -60°C bis +200°C liegen.

Die Temperierung der Bauelemente erfolgt üblicherweise auf konvektive und/oder konduktive Weise in einer wärmeisolierten Temperierkammer, die innerhalb oder außerhalb des Handlers angeordnet sein kann. Hierbei wird eine Vielzahl von Bauelementen gleichzeitig innerhalb der Temperierkammer auf die gewünschte Temperatur gebracht, bevor sie auf die Plunger aufgesetzt und von diesen zu den Kontakteinrichtungen vorgeschoben werden. Nachteilig ist hierbei, dass in der Zeit zwischen der Erwärmung und der Kontaktierung bzw. während der Kontaktierung der Bauelemente Wärmeverluste auftreten, die dazu führen, dass die Bauelemente zum Testzeitpunkt nicht mehr genau die Soll-Temperatur haben. Weiterhin können auch die einzelnen Bauelemente, die zusammen in der Temperierkammer temperiert worden sind, unterschiedliche Temperaturen haben. Ebenso können elektrische Verlustleistungen an den Bauelementen durch den elektrischen Test auftreten.

Aus der US 5,977,785 A ist ein Plunger gemäß dem Oberbegriff des Anspruchs 1 bekannt. Der dortige Plunger weist ein Kopfteil mit mehreren Saugköpfen und einen Wärmeleitkörper in der Form einer getrennt von den Saugköpfen angeordneten Kontaktplatte auf, die mittels eines warmen oder kalten Fluids erwärmt oder gekühlt werden kann. Die angesaugten Bauelemente liegen an der Kontaktplatte an und können über diese temperiert werden. Das temperierte Fluid wird in geschlossenen Kreisläufen der Kontaktplatte zugeführt und von dieser wieder abgeführt. Nachteilig ist hierbei jedoch, dass das Kopfteil komplex aufgebaut und relativ groß ausgebildet sein muss, da die Zuführ- und Abführleitungen für das temperierte Fluid relativ viel Platz in Anspruch nehmen und auch die Kontaktplatte selbst entsprechend groß dimensioniert sein muss. Für sehr kleine elektronische Bauelemente oder für Anordnungen, bei denen eine Mehrzahl von Plungerköpfen dicht nebeneinander angeordnet sein müssen, ist dieser bekannte Plungerkopf nicht geeignet.

Der Erfindung liegt die Aufgabe zugrunde, einen Plunger der eingangs genannten Art zu schaffen, mit dem Tests von elektronischen Bauelementen unter bestimmten Temperaturbedingungen auf möglichst genaue Art und Weise durchgeführt werden können. Weiterhin soll der Plunger einfach aufgebaut sein und eine geringe Baugröße im Kopfbereich haben, so dass er auch für kleine Bauelemente geeignet ist.

Diese Aufgabe wird erfindungsgemäß durch einen Plunger mit den Merkmalen des Anspruchs 1 gelöst. Vorteilhafte Ausführungsformen der Erfindung sind in den weiteren Ansprüchen beschrieben.

Erfindungsgemäß ist der Saugkopf durch den Wärmeleitkörper hindurchgeführt. Durch den erfindungsgemäßen Wärmeleitkörper erfolgt eine sehr schnelle und intensive Wärmeübertragung vom Wärmeleitkörper auf das Bauelement durch Wärmeleitung. Der Wärmeleitkörper selbst ist aufgrund seiner großen Oberfläche und seines Materials schnell mittels Fluid temperierbar, das vorzugsweise aus einem Gas, insbesondere aus gereinigter Luft oder Stickstoff, besteht. Das Fluid kann hierbei vom Innenraum des Handlers oder über Fluidleitungen des Plungers zum Wärmeleitkörper geleitet werden. Je nachdem, ob die Bauelemente bei tiefen Temperaturen, Umgebungstemperaturen oder hohen Temperaturen getestet werden sollen, wird der Wärmeleitkörper und damit das Bauelement gekühlt, auf Umgebungstemperatur gehalten bzw. erwärmt. Dadurch, dass die Temperierung der Bauelemente direkt am Plungerkopf erfolgt, kann das am Plungerkopf gehaltene Bauelement während seiner Zustellung zur zugeordneten Kontakteinrichtung und sogar noch während des Testvorgangs temperiert werden, so dass Wärmeverluste während der Zustellbewegung und während des Testvorgangs entfallen oder zumindest minimiert werden können. Die Temperierung der Bauelemente ist damit auf sehr genaue Weise möglich. Darüber hinaus kann das Kopfteil einfach aufgebaut sein und eine geringe Baugröße haben, so dass der Plunger nicht nur für großformatige, sondern auch für sehr kleine Bauelemente eingesetzt werden kann.

Gemäß einer vorteilhaften Ausführungsform weist der Wärmeleitkörper eine zentrale axiale Durchgangsöffnung auf, durch die der Saugkopf hindurchgeführt ist. Auf diese Weise kann die Kontaktfläche zwischen Wärmeleitkörper und Bauelement sehr groß gehalten werden, so dass die Temperierung des Bauelements auf besonders effektive Weise erfolgen kann. Ebenso können auch mehrere dezentrale Durchgangsöffnungen im Wärmeleitkörper vorgesehen sein, durch welche jeweils ein Saugkopf hindurchtritt.

Gemäß einer vorteilhaften Ausführungsform weist der Plungerkopf einen das angesaugte Bauelement abstützenden Haltesockel mit einem axialen Durchgang auf, in dem Wärmeleitkörper um den Saugkopf oder die Saugköpfe herum angeordnet ist. Bei dieser Ausführungsform sind somit Haltekörper und Wärmeleitkörper unterschiedliche Teile, was die Herstellung vereinfacht. Darüber hinaus ist es hierdurch auch möglich, den Wärmeleitkörper aus einem anderen Material als den Haltesockel auszubilden und dadurch deren Materialien an die jeweiligen Einsatzzwecke optimal anzupassen. Beispielsweise kann der Haltesockel aus einem elektrisch nicht leitenden Material, insbesondere einem Kunststoffmaterial, bestehen, während der Wärmeleitkörper aus einem besonders gut wärmeleitfähigen Metall bestehen kann. Alternativ hierzu ist es jedoch auch möglich, den Haltesockel selbst als Wärmeleitkörper auszubilden, d.h. den Haltesockel derart zu gestalten, dass bestimmte Bereiche des Haltesockels, die mit dem Bauelement in Kontakt gelangen, besonders gut wärmeleitend ausgebildet sind. Insbesondere kann ein derartiger Haltesockel an seiner Rückseite Rippen oder Stifte aufweisen, die seine Oberfläche vergrößern und von Fluid angeströmt werden.

Gemäß einer vorteilhaften Ausführungsform ist der Wärmeleitkörper federnd relativ zum Haltesockel angeordnet, insbesondere in Axialrichtung relativ zum Haltesockel federnd verschiebbar. Hierdurch kann auch bei Maß- oder Geometrieabweichungen der Bauelemente sichergestellt werden, dass diese möglichst vollflächig auf dem Wärmeleitkörper aufliegen, um eine gute Wärmeleitung sicherzustellen.

Besonders vorteilhaft ist es, wenn der Wärmeleitkörper kippbar relativ zur Längsachse des Plungers angeordnet ist. Hierdurch wird auch dann, wenn die Anschlussbeinchen (Pins) der Bauelemente aufgrund von Toleranzen nicht ganz einheitlich gebogen sind und der Bauelementkörper etwas aus seiner Solllage gekippt ist, wenn die Beinchen auf Stützstegen (lead backer) des Haltesockels aufliegen, ein vollflächiger Kontakt des Bauelementkörpers zum Wärmeleitkörper gewährleistet.

Gemäß einer vorteilhaften Ausführungsform besteht der Wärmeleitkörper aus einem Scheibenkörper und über den Scheibenkörper vorstehenden Rippen, wobei der Scheibenkörper eine ebene vordere Fläche aufweist, die mit dem Bauelement in Kontakt bringbar ist, und die Rippen nach hinten über den Scheibenkörper vorstehen. Auf diese Weise ist eine besonders platzsparende Ausbildung des Wärmeleitkörpers möglich, wobei gleichzeitig sehr lange, nach hinten in einen Fluidführungskanal ragende Rippen verwendet werden können, die einen besonders guten Wärmeübergang vom Fluid zum Wärmeleitkörper ermöglichen.

Gemäß einer vorteilhaften Ausführungsform weist der Haltesockel auf seiner Rückseite Fluidführungsausnehmungen auf, die in den axialen Durchgang des Haltesockels münden, so dass rückseitig an den Haltesockel herangeführtes Fluid gezielt zu dem im axialen Durchgang angeordneten Wärmeleitkörper geführt wird. Hierdurch kann auf einfache Weise sichergestellt werden, dass ein möglichst großer Anteil des zugeführten, gegebenenfalls temperierten Fluids direkt den Wärmeleitkörper anströmt, so dass dieser auf besonders effektive Weise temperiert wird.

Gemäß einer vorteilhaften Ausführungsform ist der Wärmeleitkörper durch sich in axialer Richtung erstreckende Schraubbolzen verschiebbar geführt, die an ihrem vorderen Ende einen Schraubbolzenkopf mit einer vorderen Fläche aufweisen, die einen axialen Anschlag für das Bauelement bildet, und mit einer hinteren Fläche, die einen axialen Anschlag für den Wärmeleitkörper bildet. Zweckmäßigerweise wird hierbei der Wärmeleitkörper durch Federn nach vorne gedrückt, die um die Schraubbolzen herum angeordnet sind. Hierdurch lässt sich auf eine relativ einfache und platzsparende Weise eine federnde, nachgiebige Halterung des Wärmeleitkörpers im Haltesockel bewerkstelligen.

Die Erfindung wird nachfolgend anhand von Zeichnungen beispielhaft näher erläutert. Es zeigen:
- Figur 1 :: eine perspektivische Darstellung eines Plungers, wobei ein Plungerkopf getrennt von den übrigen Teilen des Plungers darge- stellt ist;
- Figur 2 :: einen Längsschnitt durch einen Plungerkopf mit einem schematisch dargestellten Wärme- leitkörper, jedoch ohne Saugkopf;
- Figur 3 :: eine Draufsicht auf den Wärmeleitkörper von Figur 2;
- Figur 4 :: eine Draufsicht auf ein elektronisches Bauelement;
- Figur 5 :: eine perspektivische Darstellung einer al- ternativen Ausführungsform eines Plunger- kopfs schräg von vorne;
- Figur 6 :: eine perspektivische Darstellung des Plun- gerkopfs von Figur 5 schräg von hinten;
- Figur 7 :: eine Explosionsdarstellung des Plunger- kopfs der Figuren 5 und 6;
- Figur 8 :: eine Ansicht von vorn auf den Plungerkopf von Figur 5;
- Figur 9 :: einen Schnitt längs der Linie IX-IX von Figur 8; und
- Figur 10 :: einen Schnitt längs der Linie X-X von Fi- gur 8, wobei das Bauelement abgehoben dar- gestellt ist.

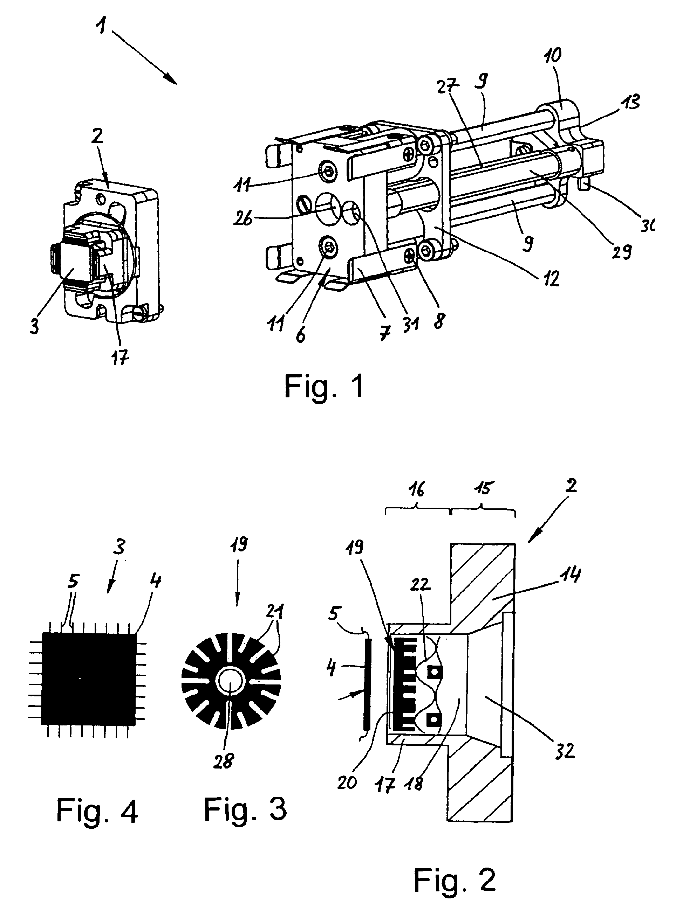

Aus Figur 1 ist ein teilweise in Explosionsdarstellung dargestellter Plunger 1 ersichtlich. Der Plunger 1 weist einen Plungerkopf 2 auf, der an seinem vorderen Ende ein elektronisches Bauelement 3 mittels Saugkraft halten kann.

Bei dem Bauelement 3 handelt es sich im gezeigten Ausführungsbeispiel um ein integrierte Schaltungen aufweisendes Bauelement, kurz IC genannt, das, wie aus Figur 4 ersichtlich, einen Bauelementkörper 4 und seitlich davon abstehende Anschlussbeinchen 5 aufweist. Der Plunger 1 kann jedoch auch zum Halten und Bewegen anderer Bauelemente verwendet werden, beispielsweise von BGA- oder QFN-Bauelementen.

Der Plungerkopf 2 ist auf einem quaderförmigen Basiskörper 6 aufsetzbar und wird auf diesem in seitlicher Richtung mittels Federzungen 7 gehalten, die mittels Schrauben 8 am Basiskörper 6 befestigt sind und in axialer Richtung nach vorn über den Basiskörper 6 vorstehen. Auf diese Weise kann der Plungerkopf 2 zusammen mit dem Bauelement 3 in seitlicher Richtung geringfügig verschoben werden, wenn der Plungerkopf 2 beim Vorschieben des Plungers 1 in eine nicht dargestellte Zentriereinrichtung einfährt, die in der Nähe eines nicht dargestellten Kontaktsockels angeordnet ist.

Der Basiskörper 6 ist mittels zweier Führungsstangen 9, die parallel zur Längsachse des Plungers 1 angeordnet sind, mit einem hinteren Endstück 10 verbunden. Aus Figur 1 sind Schrauben 11 ersichtlich, mit denen die Führungsstangen 9 an ihrem vorderen Ende am Basiskörper 6 festgeschraubt sind.

Mittels der beiden Führungsstangen 9 ist der Plunger 1 längsverschiebbar an einer Führungseinrichtung 12 gehaltert, die nicht näher ersichtliche Führungshülsen aufweist, in denen die Führungsstangen 9 verschiebbar geführt sind. Die Führungseinrichtung 12 kann in einer nicht näher dargestellten Weise beispielsweise an einem Umlaufwagen oder an einer Schwenkeinrichtung befestigt sein, mit dem bzw. der der Plunger 1 zusammen mit dem aufgesetzten Bauelement 3 in eine Position gebracht werden kann, in welcher der Plunger 1 geradlinig (in Figur 1 nach links) in eine Kontaktposition vorgeschoben werden kann, in der die Anschlussbeinchen 5 des Bauelements 3 (Figur 4) auf entsprechende, nicht dargestellte Anschlusskontakte eines Kontaktsockels aufgesetzt werden. Die Vorwärtsbewegung erfolgt dabei mittels einer nicht dargestellten Vorschubeinrichtung, welche auf eine hintere Stirnfläche 13 des hinteren Endabschnitts 10 drückt. Das Zurückführen des Plungers 1 in seine Ausgangslage erfolgt über eine nicht dargestellte Rückholfeder, die mit ihrem hinteren Ende an der Plungerführungseinrichtung 12 und mit ihrem vorderen Ende am Basiskörper 11 befestigt ist.

Wie aus den Figuren 1 und 2 ersichtlich, weist der Plungerkopf 2 einen Haltesockel 14 auf, der aus einem quaderförmigen Sockelabschnitt 15 und einem im Durchmesser verringerten vorderen Sockelabschnitt 16 besteht, der in axialer Richtung über den Sockelabschnitt 15 vorsteht. Der vordere Sockelabschnitt 16 weist vier Beinchenstützstege 17 (lead backer) auf, welche auf vier Seiten einen zentralen, axialen Durchgang 18 des Haltesockels 14 begrenzen. Auf den vorderen Stirnflächen der Beinchenstützstege 17 kommen die Anschlussbeinchen 5 der Bauelemente 3 zu liegen, wenn die Bauelemente 3 am Plungerkopf 2 gehalten werden.

Wie in Figur 2 schematisch dargestellt, ist im zentralen Durchgang 18 ein Wärmeleitkörper 19 angeordnet, dessen vordere Stirnfläche 20 nahe dem vorderen Ende des vorderen Sockelabschnitts 16 angeordnet ist. Der Wärmeleitkörper 19 besteht aus einem scheibenförmigen Körper mit einer Vielzahl von Rippen 21, die sich sowohl in radialer Richtung nach außen als auch nach hinten, d.h. gegen die Fluidströmungsrichtung, erstrecken. Weiterhin besteht der Wärmeleitkörper 19 aus einem gut wärmeleitenden Material. Die vordere Stirnfläche 20 des Wärmeleitkörpers 19 ist eben ausgebildet und derart angeordnet, dass der Bauelementkörper 4 vollflächig mit der vorderen Stirnfläche 20 in Kontakt gelangen kann, wenn das Bauelement 3 auf dem Plungerkopf 2 aufgesetzt wird.

Der Außendurchmesser des Wärmeleitkörpers 19 ist nur geringfügig kleiner als der Durchmesser des Durchgangs 18. Wird Fluid mit einer bestimmten Temperatur von hinten her, d.h. in Figur 2 von rechts, in den Durchgang 18 eingeleitet, kann somit nur ein sehr kleiner Teil des Fluids am Wärmeleitkörper 19 vorbeiströmen, ohne mit diesem in Kontakt zu gelangen. Vielmehr ist das Fluid gezwungen, in den Zwischenräumen und Schlitzen zwischen den Rippen 21 hindurchzuströmen, wodurch ein intensiver Kontakt des Fluids mit dem Wärmeleitkörper 19 sichergestellt wird.

Um zu gewährleisten, dass das Bauelement 3 auch dann eben auf dem Wärmeleitkörper 19 aufliegt, wenn nicht alle Anschlussbeinchen 5 des Bauelements 3 die optimale Ausrichtung haben, ist der Wärmeleitkörper 19, wie in Figur 2 schematisch dargestellt, mittels einer Federeinrichtung 22 federnd im Durchgang 18 abgestützt. Diese Federeinrichtung 22 ist so ausgebildet, dass der Wärmeleitkörper 19 innerhalb des Durchgangs 18 geringfügig gekippt, d.h. in Schräglagen gebracht werden kann, um sich einer eventuellen Schräglage des Bauelementkörpers 4 anzupassen und dadurch einen innigen Kontakt zum Bauelementkörper 4 aufrecht zu erhalten.

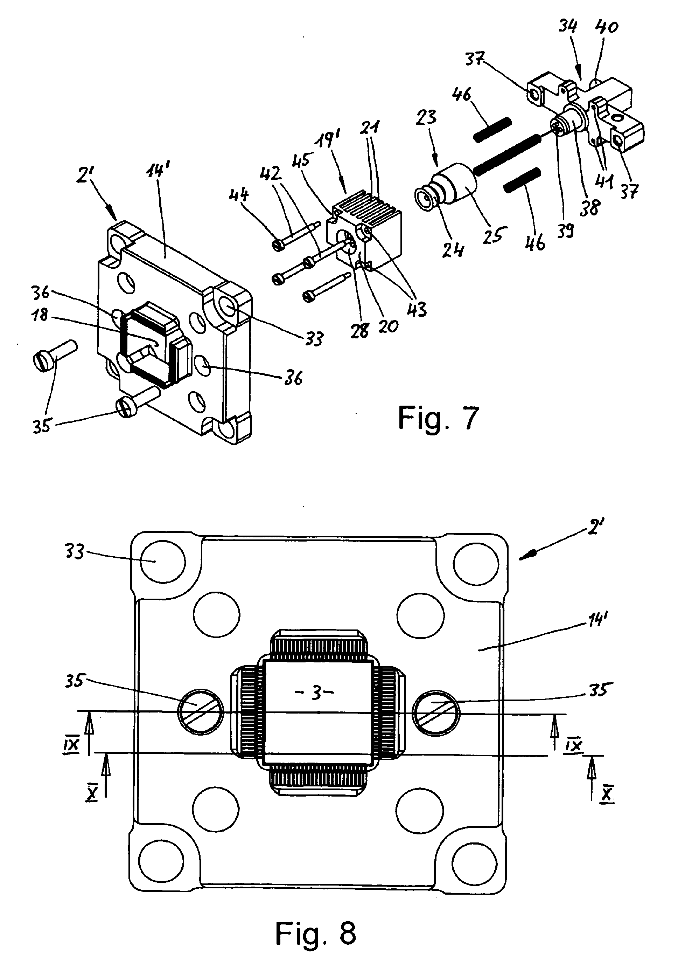

Um das Bauelement 3 am Haltesockel 14 festzusaugen, weist der Plungerkopf 2 einen flexiblen Saugkopf auf, der gleich ausgebildet sein kann wie ein aus Figur 7 ersichtlicher Saugkopf 23. Dieser Saugkopf 23 besteht aus einem vorderen Saugbalg 24 und einem daran anschließenden Schlauchstutzen 25. Bei dem in Figur 1 dargestellten Ausführungsbeispiel steht der Saugkopf 23 mit einem zentralen Saugkanal 26 in Verbindung, der durch den Basiskörper 6 hindurchgeführt und mit einer Saugleitung 27 verbunden ist, die parallel und zwischen den Führungsstangen 9 zum hinteren Endstück 10 geführt und dort mit einer nicht dargestellten Vakuumleitung in Verbindung ist, die zu einer Unterdruckerzeugungseinrichtung führt.

Der Saugkopf 23 ist, obwohl dies in Figur 2 nicht dargestellt ist, mittig innerhalb des Durchgangs 18 angeordnet, wobei sich der Saugbalg 24 durch eine mittige Durchgangsöffnung 28 des Wärmeleitkörpers 19 (Figur 3) hindurcherstreckt. Das vordere Ende des Saugbalgs 24 steht hierbei in axialer Richtung etwas nach vorn über die vordere Stirnfläche 20 des Wärmeleitkörpers 19 vor. Der Bauelementkörper 4 des ansaugenden Bauelements 3 kann somit mit dem Saugkopf 23 in Kontakt gebracht und von diesem gegen den Wärmeleitkörper 19 gezogen werden, indem sich der Saugbalg 24 verkürzt. Aufgrund der Saugkraft wird anschließend das Bauelement 3 zusammen mit dem Wärmeleitkörper 19, der aufgrund der Federeinrichtung 22 in axialer Richtung nachgiebig und federnd gelagert ist, weiter soweit nach hinten gezogen, bis die Anschlussbeinchen 5 des Bauelements 3 auf den Beinchenstützstegen 17 aufliegen.

Um das Bauelement 3 auf eine bestimmte Temperatur, die beispielsweise zwischen -60°C und +200°C liegen kann, zu temperieren, weist der aus Figur 1 ersichtliche Plunger 1 weiterhin eine Fluidzufuhrleitung 29 auf, die über einen rückseitigen Anschlussstutzen 30 mit Fluid versorgt wird. Innerhalb der Fluidzufuhrleitung 29 kann sich eine Heiz- oder Abkühleinrichtung für das zugeführte Fluid befinden. Im Falle einer Heizeinrichtung handelt es sich zweckmäßigerweise um eine Heizspirale, mittels der das vorbeiströmende Fluid auf die gewünschte Temperatur erwärmt wird. Alternativ hierzu ist es jedoch möglich, dass ein bereits sich auf der gewünschten Temperatur befindendes oder in gewissem Maß vortemperiertes Fluid, insbesondere gereinigte und temperierte Luft, bereits über den Anschlussstutzen 30 zugeführt und in die Fluidzufuhrleitung 29 eingeleitet wird.

Die Fluidzufuhrleitung 29 ist mit ihrem vorderen Ende an einem Fluidzufuhrkanal 31 angeschlossen, der den Basiskörper 11 durchdringt. Der Fluidzufuhrkanal 31 ist mit einer Fluidverteilkammer 32 (Figur 2) in Verbindung, die sich im Plungerkopf 2 befindet. Diese Fluidverteilkammer 32 besteht aus einem sich nach hinten kegelförmig erweiternden Raum, in den der Fluidzufuhrkanal 31 des Basiskörpers 6 mündet. Die Fluidverteilkammer 32 stellt den hinteren Abschnitt des zentralen Durchgangs 18 dar.

Soll das Bauelement 3 temperiert werden, wird ein entsprechend temperiertes Fluid über die Fluidzufuhrleitung 29 zum zentralen Durchgang 18 geleitet, wodurch der Wärmeleitkörper 19 intensiv angeströmt und entsprechend temperiert wird. Ein Teil des Fluids gelangt durch die Schlitze und Zwischenräume zwischen den Rippen 21 des Wärmeleitkörpers 19 hindurch auch direkt auf das Bauelement 3. Das Bauelement 3 wird somit durch das Fluid und durch Wärmeleitung zwischen dem Wärmeleitkörper 21 und dem Bauelementkörper 4 schnell und intensiv auf die Temperatur des Fluids gebracht.

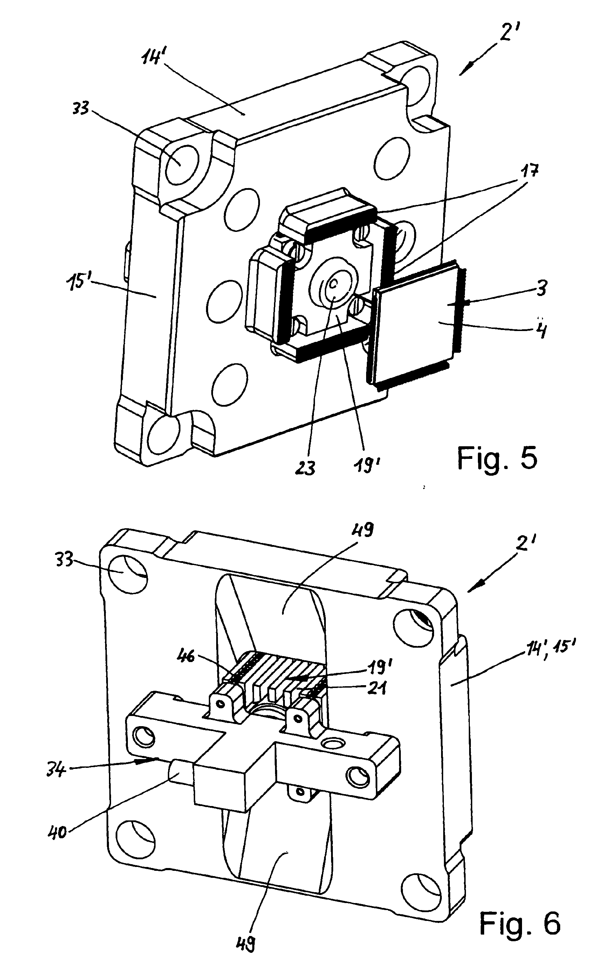

Anhand der Figuren 5 bis 10 wird nachfolgend ein zweites Ausführungsbeispiel eines Plungerkopfes 2' beschrieben.

Der Plungerkopf 2' weist einen Haltesockel 14' auf, der ganz ähnlich zum Haltesockel 14 der ersten Ausführungsform aufgebaut ist, jedoch über vier Befestigungsbohrungen 33, die sich in den Eckbereichen des quaderförmigen Sockelabschnitts 15' befinden, an einer nicht dargestellten Halteeinrichtung befestigt werden kann, die wiederum an Führungsstangen ähnlich zu den Führungsstangen 9 von Figur 1 befestigt ist oder aus den Führungsstangen 9 selbst bestellt.

Im zentralen Durchgang 18 des Haltesockels 14' ist ein Wärmeleitkörper 19' eingesetzt, der im Wesentlichen quaderförmig ausgebildet ist, jedoch auch anders geformt, insbesondere zylinderförmig, sein kann. Wie aus Figur 7 ersichtlich, weist das Wärmeleitelement 19' eine ebene vordere Stirnfläche 20 und rückseitige Rippen 21 auf. Der im Zusammenhang mit dem ersten Ausführungsbeispiel bereits beschriebene Saugkopf 23 durchdringt wiederum eine mittige, axiale Durchgangsöffnung 28 des Wärmeleitkörpers 19'.

Der Wärmeleitkörper 19' ist mit geringem seitlichen Abstand in den zentralen Durchgang 18 des Haltesockels 14' eingesetzt.

An der Rückseite des Haltesockels 14' ist ein Halteelement 34 mittels Schrauben 35 festgeschraubt, welche Bohrungen 36 des Haltesockels 14' durchdringen und in Schraubenlöcher 37 des Halteelements 34 einschraubbar sind. Das Halteelement 34 überspannt den zentralen Durchgang 18 des Haltesockels 14'.

Das Halteelement 34 dient einerseits als Anschlusselement für den Saugkopf 23 und andererseits zur federnden Halterung des Wärmeleitkörpers 19'. Das Halteelement 34 weist einen vorderen Saugstutzen 38 auf, auf dem der Schlauchstutzen 25 des Saugkopfes 23 aufgesteckt werden kann. Vom Saugstutzen 38 erstrecken sich eine oder mehrere Saugleitungen 39 (Figur 7) zu einem hinteren Saugstutzen 40. Dieser Saugstutzen 40 ist über eine nicht dargestellte Saugleitung mit einer Unterdruckerzeugungseinrichtung verbunden.

Zur federnden Halterung des Wärmeleitkörpers 19' weist das Halteelement 34 vier Schraubenlöcher 41 auf, in die hintere Gewindeabschnitte von vier länglichen Schraubbolzen 42 eingeschraubt werden können. Die Schraubbolzen 42 erstrecken sich parallel zueinander und in Axialrichtung des Plungers 1. Weiterhin durchdringen die Schraubbolzen 42 axiale Durchgangsbohrungen 43, die sich in den Eckenbereichen des Wärmeleitkörpers 19' befinden und einen wesentlich größeren Durchmesser als die Schraubbolzen 42 haben. Die Schraubbolzen 42 weisen an ihrem vorderen Ende einen Schraubbolzenkopf 44 auf, der in Vertiefungen 45 im vorderen Endbereich des Wärmeleitkörpers 19' angeordnet ist. Die Höhe der Schraubbolzenköpfe 44 ist dabei etwas geringer als die Tiefe der Vertiefungen 45.

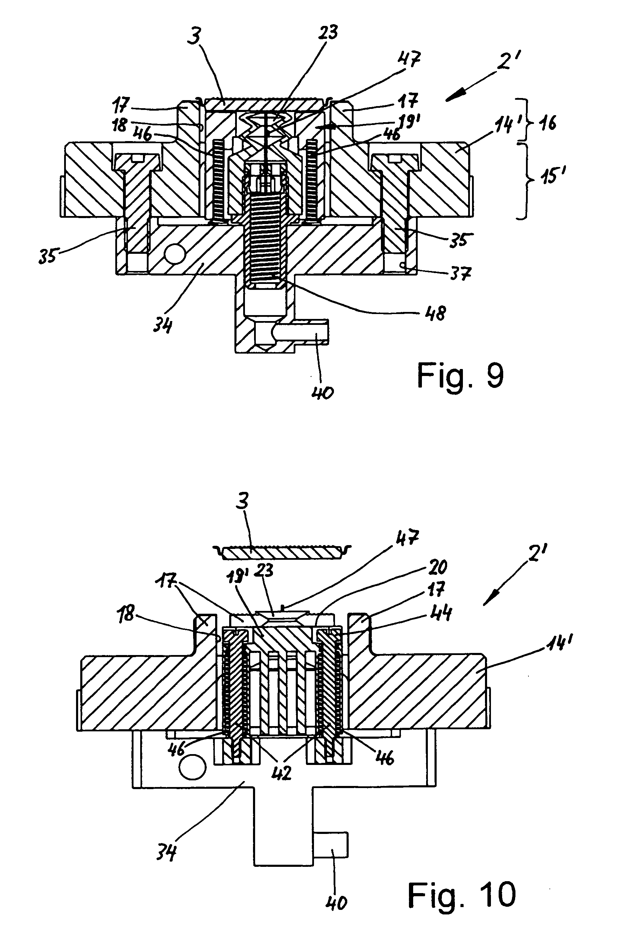

Wie insbesondere aus Figur 10 ersichtlich, wird der Wärmeleitkörper 19' von Federn 46 in der Form von Druckfedern nach vorne gedrängt, die um die Schraubbolzen 42 herum angeordnet sind und von diesen geführt werden. An ihrem hinteren Ende sind die Federn 46 am Halteelement 34 abgestützt, während sie an ihrem vorderen Ende in einem vorderen Bereich des Wärmeleitkörpers 19' abgestützt sind. Der Verschiebeweg des Wärmeleitkörpers 19' nach vorne wird durch die Schraubbolzenköpfe 44 begrenzt, die somit als Axialanschlag wirken. Solange kein Bauelement 3 auf den Plungerkopf 2' aufgesetzt ist, ist, wie aus Figur 10 ersichtlich, die vordere Stirnfläche der Schraubbolzenköpfe 44 relativ zur vorderen Stirnfläche 20 des Wärmeleitkörpers 19' geringfügig zurückversetzt. Wird dagegen ein Bauelement 3 auf den Saugkopf 23 aufgesetzt und von diesem angesaugt, drückt der Bauelementkörper 4 den Wärmeleitkörper 19' zurück, bis der Bauelementkörper 4 an den vorderen Stirnflächen der Schraubbolzenköpfe 44 anschlägt. Die Schraubbolzen 22 wirken somit als Axialanschläge für das Bauelement 3, wobei die Lage dieser Anschläge durch mehr oder weniger weites Einschrauben der Schraubbolzen 42 in die Schraubenlöcher 41 verstellt werden kann.

Wie insbesondere aus Figur 9 ersichtlich, weist der Plungerkopf 2' weiterhin eine sich axial erstreckende Auswurfnadel 47 auf, die sich mittig durch den Saugkopf 23 hindurch erstreckt und am hinteren Ende an einer Auswurffeder 48 abgestützt ist. Ist kein Bauelement 3 auf den Plungerkopf 2' aufgesetzt, steht die Auswurfnadel 47 geringfügig nach vorne über den Saugkopf 23 vor, wie aus Figur 10 ersichtlich. Wird ein Bauelement 3 aufgesetzt, drückt der Bauelementkörper 4 die Auswurfnadel 47 entgegen der Vorspannkraft der Feder 48 zurück, wie in Figur 9 dargestellt. Die Auswurfnadel 47 unterstützt durch die Vorspannkraft der Auswurffeder 48 das Abheben des Bauelements 3 vom Plungerkopf 2', wenn nach Beendigung eines Testvorgangs das Bauelement 3 vom Plungerkopf 2' entfernt werden soll und mittels des Saugkopfs 23 keine Saugkraft mehr aufgebracht wird.

Bei der in den Figuren 5 bis 10 dargestellten Ausführungsform steht der Wärmeleitkörper 19' nicht oder nur geringfügig nach hinten über den Haltesockel 14' vor, wobei er rückseitig teilweise durch das Halteelement 34 abgedeckt ist. Um dennoch zu gewährleisten, dass der Wärmeleitkörper 19' auf effektive Weise mit temperiertem Fluid angeströmt werden kann, weist der Haltesockel 14' an seiner Rückseite Fluidführungsausnehmungen 49 (Figur 6) auf, welche sich vom zentralen Durchgang 18 seitlich nach außen bis in die Nähe zweier gegenüberliegender Randbereiche des Haltesockels 14' erstrecken. Durch diese Fluidführungsausnehmungen 49 wird ein Teil der Rippen 21 freigelegt, so dass diese von Fluid, das gegen die Rückseite des Haltesockels 14' geleitet und über die Fluidführungsausnehmungen 49 zum Wärmeleitkörper 19' geführt wird, besser angeströmt und entsprechend temperiert werden können.

## Patentansprüche

1. Plunger zum Halten und Bewegen von elektronischen Bauelementen, insbesondere zum Zuführen und Wegbewegen von IC's zu bzw. von einer mit einer Testvorrichtung verbundenen Kontakteinrichtung, mit einem Plungerkopf (2, 2'), der mindestens einen Saugkopf (23) zum Ansaugen eines Bauelements (3) und einen Wärmeleitkörper (19, 19') aufweist, der durch ein Fluid temperierbar und derart angeordnet ist, dass das angesaugte Bauelement (3) am Wärmeleitkörper (19, 19') anliegt, **dadurch gekennzeichnet, dass** der Saugkopf (23) durch den Wärmeleitkörper (19, 19') hindurchgeführt ist.

2. Plunger nach Anspruch 1, **dadurch gekennzeichnet, dass** der Wärmeleitkörper (19, 19') eine zentrale, axiale Durchgangsöffnung (28) aufweist, durch die der Saugkopf (23) hindurchgeführt ist.

3. Plunger nach Anspruch 1, **dadurch gekennzeichnet, dass** der Wärmeleitkörper eine Mehrzahl von Durchgangsöffnungen (28) aufweist, durch die jeweils ein Saugkopf (23) hindurchtritt.

4. Plunger nach einem der Ansprüche 1 bis 3, **dadurch gekennzeichnet, dass** der Plungerkopf (2, 2') einen, das angesaugte Bauelement (3) abstützenden Haltesockel (14, 14') mit einem axialen Durchgang (18) aufweist, in dem der Wärmeleitkörper (19, 19') um den Saugkopf (23) herum angeordnet ist.

5. Plunger nach Anspruch 4, **dadurch gekennzeichnet, dass** der Wärmeleitkörper (19, 19') federnd relativ zum Haltesockel (14, 14') angeordnet ist.

6. Plunger nach Anspruch 4 oder 5, **dadurch gekennzeichnet, dass** der Wärmeleitkörper (19, 19') kippbar relativ zur Längsachse des Plungers (1) angeordnet ist.

7. Plunger nach einem der Ansprüche 1 bis 6, **dadurch gekennzeichnet, dass** der Wärmeleitkörper (19, 19') aus einem Scheibenkörper und über den Scheibenkörper vorstehenden Rippen (21) besteht, wobei der Scheibenkörper eine ebene vordere Stirnfläche (20) aufweist, die mit dem Bauelement (3) in Kontakt bringbar ist, und die Rippen (21) nach hinten über den Scheibenkörper vorstehen.

8. Plunger nach einem der Ansprüche 4 bis 7, **dadurch gekennzeichnet, dass** der Haltesockel (14') an seiner Rückseite Fluidführungsausnehmungen (49) aufweist, die in den axialen Durchgang (18) des Haltesockels (14') münden, so dass rückseitig an den Haltesockel (14') herangeführtes Fluid gezielt zu dem im axialen Durchgang (18) angeordneten Wärmeleitkörper (19') geführt wird.

9. Plunger nach einem der Ansprüche 5 bis 8, **dadurch gekennzeichnet, dass** der Wärmeleitkörper (19') durch sich in axialer Richtung erstreckende Schraubbolzen (42) verschiebbar geführt ist, die an ihrem vorderen Ende einen Schraubbolzenkopf (44) mit einer vorderen Fläche aufweisen, die einen axialen Anschlag für das Bauelement (3) bildet, und mit einer hinteren Fläche, die einen axialen Anschlag für den Wärmeleitkörper (19') bildet.

10. Plunger nach Anspruch 9, **dadurch gekennzeichnet, dass** der Wärmeleitkörper (19') durch Federn (46) nach vorne gedrückt wird, die um die Schraubbolzen (42) herum angeordnet sind.

11. Plunger nach einem Ansprüche 1 bis 3, **dadurch gekennzeichnet, dass** der Plungerkopf (2, 2') einen Haltesockel (14, 14') aufweist, der als Wärmeleitkörper ausgebildet ist.

12. Plunger nach Anspruch 11, **dadurch gekennzeichnet, dass** der Haltesockel (14, 14') an seiner Rückseite Rippen aufweist, die seine Oberfläche vergrößern und damit die Wärmeübertragung vom Fluid auf den Haltesockel (14, 14') verbessern.

## Claims

1. Plunger for holding and moving electronic components, in particular for moving ICs towards and away from a contacting means which is connected to a test device, having a plunger head (2, 2'), which comprises at least a suction head (23) for sucking in a component (3) and a heat-conducting body (19, 19') which can be temperature-controlled by a fluid, and is arranged in such a way that the sucked-in component (3) rests against the heat-conducting body (19, 19'), **characterised in that** the suction head (23) is guided through the heat-conducting body (19, 19').

2. Plunger according to claim 1, **characterised in that** the heat-conducting body (19, 19') comprises a central axial through-opening (28), through which the suction head (23) is guided.

3. Plunger according to claim 1, **characterised in that** the heat-conducting body comprises a plurality of through-openings (28), through each of which a suction head (23) penetrates.

4. Plunger according to any one of claims 1 to 3, **characterised in that** the plunger head (2, 2') comprises a retaining base (14, 14'), which supports the sucked-in component (3) and has an axial passage (18) in which the heat-conducting body (19, 19') is arranged around the suction head (23).

5. Plunger according to claim 4, **characterised in that** the heat-conducting body (19, 19') is arranged resiliently relative to the retaining base (14, 14').

6. Plunger according to either claim 4 or claim 5, **characterised in that** the heat-conducting body (19, 19') is arranged tiltably relative to the longitudinal axis of the plunger (1).

7. Plunger according to any one of claims 1 to 6, **characterised in that** the heat-conducting body (19, 19') consists of a disc-shaped body and fins (21) projecting beyond the disc-shaped body, the disc-shaped body comprising a planar front end face (20) which can be brought into contact with the component (3), and the fins (21) projecting rearwards beyond the disc-shaped body.

8. Plunger according to any one of claims 4 to 7, **characterised in that** the retaining base (14') comprises fluid guide recesses (49) in the rear side thereof, which open into the axial passage (18) in the retaining base (14') in such a way that fluid conveyed to the rear side of the retaining base (14') can be guided in a targeted manner towards the heat-conducting body (19') arranged in the axial passage (18).

9. Plunger according to any one of claims 5 to 8, **characterised in that** the heat-conducting body (19') is displaceably guided by bolts (42), extending in the axial direction, which have at the front end thereof a bolt head (44) with a front face which forms an axial stop for the component (3), and have a rear face which forms an axial stop for the heat-conducting body (19').

10. Plunger according to claim 9, **characterised in that** the heat-conducting body (19') is pushed forwards by springs (46) which are arranged around the bolts (42).

11. Plunger according to any one of claims 1 to 3, **characterised in that** the plunger head (2, 2') comprises a retaining base (14, 14') which is formed as a heat-conducting body.

12. Plunger according to claim 11, **characterised in that** the retaining base (14, 14') has fins on the rear side thereof which increase the surface area thereof and thus improve the transfer of heat from the fluid to the retaining base (14, 14').

## Revendications

1. Plongeur pour maintenir et déplacer des composants électroniques, en particulier pour amener et enlever des circuits intégrés vers et depuis un dispositif de mise en contact relié à un dispositif de test, comprenant une tête de plongeur (2, 2'), qui comprend au moins une tête d'aspiration (23) pour aspirer un composant (3), et un corps thermoconducteur (19, 19'), lequel peut être tempéré par un fluide et est agencé de telle façon que le composant aspiré (3) s'applique contre le corps thermoconducteur (19, 19'), **caractérisé en ce que** la tête d'aspiration (23) est passée à travers le corps thermoconducteur (19, 19').

2. Plongeur selon la revendication 1, **caractérisé en ce que** le corps thermoconducteur (19, 19') comporte une ouverture traversante axiale centrale (28), à travers laquelle est passée la tête d'aspiration (23).

3. Plongeur selon la revendication 1, **caractérisé en ce que** le corps thermoconducteur (19, 19') comporte une pluralité d'ouvertures traversantes (28) à travers lesquelles passe respectivement une tête d'aspiration (23).

4. Plongeur selon l'une des revendications 1 à 3, **caractérisé en ce que** la tête de plongeur (2, 2') comprend un socle de maintien (14, 14'), qui soutient le composant aspiré (3) et présente une traversée axiale (18), dans lequel le corps thermoconducteur (19, 19') est agencé tout autour de la tête d'aspiration (23).

5. Plongeur selon la revendication 4, **caractérisé en ce que** le corps thermoconducteur (19, 19') est agencé avec effet élastique par rapport au socle de maintien (14, 14').

6. Plongeur selon la revendication 4 ou 5, **caractérisé en ce que** le corps thermoconducteur (19, 19') est agencé avec faculté de basculement par rapport à l'axe longitudinal du plongeur (1).

7. Plongeur selon l'une des revendications 1 à 6, **caractérisé en ce que** le corps thermoconducteur (19, 19') est constitué d'un corps en forme de plaque et de nervures (21) dépassant au-dessus du corps en forme de plaque, ledit corps en forme de plaque présentant une surface frontale avant plane (20) qui peut être amenée en contact avec le composant (3), et les nervures (21) dépassent vers l'arrière au-delà du corps en forme de plaque.

8. Plongeur selon l'une des revendications 4 à 7, **caractérisé en ce que** le socle de maintien (14') présente sur sa face postérieure des évidements de guidage de fluide (49) qui débouchent dans la traversée axiale (18) du socle de maintien (14'), de sorte que le fluide amené au socle de maintien (14') sur le côté postérieur est amené de façon ciblée au corps thermoconducteur (19') agencé dans la traversée axiale (18).

9. Plongeur selon l'une des revendications 5 à 8, **caractérisé en ce que** le corps thermoconducteur (19') est guidé en déplacement par des boulons vissés (42) s'étendant en direction axiale, lesquels présentent à leurs extrémités avant une tête de boulon (44) avec une surface antérieure qui forme une butée axiale pour le composant (3), et avec une surface postérieure qui forme une butée pour le corps thermoconducteur (19').

10. Plongeur selon la revendication 9, **caractérisé en ce que** le corps thermoconducteur (19') est poussé vers l'avant par des ressorts (46) qui sont agencés tout autour des boulons vissés (42).

11. Plongeur selon l'une des revendications 1 à 3, **caractérisé en ce que** la tête de plongeur (2, 2') comporte un socle de maintien (14, 14') qui est réalisé comme corps thermoconducteur.

12. Plongeur selon la revendication 11, **caractérisé en ce que** le socle de maintien (14, 14') comporte sur sa face postérieure des nervures qui augmentent sa surface et améliorent ainsi le transfert thermique depuis le fluide vers le socle de maintien (14, 14').
